Europäisches Patentamt

European Patent Office

Office européen des brevets

(11) Veröffentlichungsnummer: **0 329 845**
**A1**

## (12) EUROPÄISCHE PATENTANMELDUNG

(21) Anmeldenummer: 88120848.2

(22) Anmeldetag: 14.12.88

(51) Int. Cl.⁴: **C23C 16/18 , C23C 16/56 , H05K 3/00**

(30) Priorität: 26.02.88 DE 3806587

(43) Veröffentlichungstag der Anmeldung:
30.08.89 Patentblatt 89/35

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Suhr, Harald, Prof. Dr.rer.nat.**
**Weissdornweg 2**
**D-7400 Tübingen(DE)**
Erfinder: **Feurer, Ernst, Dr.**
**Fliederweg 11**
**CH-5600 Lenzburg(CH)**
Erfinder: **Haag, Christa**
**Kirchstrasse 9**
**D-7404 Ofterdingen(DE)**
Erfinder: **Nauenburg, Klaus Dieter**
**Sigwart Strasse 11**
**D-7400 Tübingen(DE)**
Erfinder: **Schmidt, Rainer**
**Wöhrwoldweg 43**
**D-7410 Reutlingen(DE)**

(54) **Verfahren zur Herstellung fest haftender metallischer Strukturen auf Polyimid.**

(57) Die Erfindung betrifft ein Verfahren zur Herstellung metallischer Strukturen auf Nichtleitern durch Zersetzung metallorganischer Verbindungen in einer Glimmentladung unter Bildung eines metallischen Films, dadurch gekennzeichnet, daß als Nichtleiter Polyimid verwendet wird.

EP 0 329 845 A1

# VERFAHREN ZUR HERSTELLUNG FEST HAFTENDER METALLISCHER STRUKTUREN AUF POLYIMID

Die vorliegende Erfindung betrifft ein Verfahren zur Herstellung metallischer Strukturen auf Nichtleitern durch Zersetzung metallorganischer Verbindungen in einer Glimmentladung unter Bildung eines metallischen Films.

Die Herstellung metallischer Filme auf Kunststoffen erfolgt in konventioneller Weise normalerweise naßchemisch, dadurch, daß die zu metallisierenden Teile in eine speziell für ein Substrat formulierte Reihe von Reinigungs-, Ätz-, Konditionierungs,Aktivierungs- und Metallisierungsbäder getaucht werden. Hierbei wird die Oberfläche nach der Reinigung und Konditionierung zunächst mit edelmetallhaltigen Lösungen bekeimt und danach auf den aktivierten Flächen nach herkömmlichen Verfahren metallisiert.

Die Behandlungsbäder sind in der Regel wässrige Lösungen. enthalten zum Teil jedoch auch organische Lösungsmittel. Nachteil dieser Formulierungen ist zum einen die Flüchtigkeit und die Giftigkeit dieser organischen Verbindungen, die entsprechende Sicherheitsvorkehrungen erforderlich machen.

Zum andern nehmen die meisten Kunststoffe, insbesondere aber Polyimid Wasser auf. Diese Wasseraufnahme kann bis 4 Liter bei einem Metallisierungsprozess. der in wässriger Lösung durchgeführt wird. nur dann durch Ausheizen rechtzeitig gemacht werden, wenn die Metallschicht porös ist oder erhebliche Teile der Kunstoberfläche nicht metallisiert werden.

Beide Fälle sind unter technischen Gesichtspunkten der Anwendung unerwünschte Einschränkungen, da porenfreie und beidseitig beschichtete Polyimid-Substrate benötigt werden. Enthalten solche beidseitig beschichteten Substrate aber Wasser, so kommt es zu starker Temperaturerhöhung, insbesondere beim Lötvorgang zu so heftigen Ausgärungen (Wasserdampf), daß das Material zerstört wird.

Ein weiterer wesentlicher Nachteil der naßchemischen Verfahren besteht darin. daß relativ komplizierte Vorbehandlungssequenzen vorzusehen sind, ehe metallisiert wird, um die gewünschten Haftungswerte zu erreichen. Dabei sind in jedem Falle die verfahrenstechnischen Parameter, wie zum Beispiel Temperatur und Behandlungszeit in engen Grenzen zu halten, so daß unter Umständen eine umfangreiche Prozeßkontrolle benötigt wird. Die Gefahr der Kontamination der Behandlungsbäder durch prozeßbedingte Verfahrensschwankungen ist groß und kann deutliche Qualitätsschwankungen zur Folge haben. Die Aggresivität der Behandlungslösungen wirkt sich unter Umständen qualitätsmindernd auf Abdecklacke oder -folien aus.

Ein anderes Beschichtungsverfahren ist die thermische Zersetzung von flüchtigen Metallverbindungen. Dieses Verfahren setzt sehr hohe Substrattemperaturen (mind. 200° C in der Praxis aber 300 - 1000° C) voraus, die aber im Falle der genannten Materialien nicht oder nur unter Gefahr der Materialschädigung erreicht werden dürfen.

Die vorliegende Erfindung hat zur Aufgabe, fest haftende metallische Strukturen auf Polyimid herzustellen. Die so hergestellten Halbzeuge werden zum Beispiel in der Elektronikindustrie verwendet, insbesondere für die Herstellung von Leiterplatten, Hybridschaltungen, Chip Carriers, dreidimensionalen Formkörpern mit Leiterbahnstrukturen oder ganzflächig metallisierten dreidimensionalen Formkörpern (Gehäuse), für die Abschirmung elektromagnetischer Felder.

Unter Polyimid sollen hierin auch dessen Substrate und solche Oberflächen verstanden werden, die aus gelöstem und/oder nachgehärtetem Polyimid erzeugt werden.

Diese Aufgabe wird gelöst durch ein Verfahren gemäß dem kennzeichnenden Teil des Patentanspruchs.

Vorteilhafte Ausführungen dieses Verfahrens sind in den Unteransprüchen beschrieben.

Das erfindungsgemäße Verfahren überwindet die Nachteile der bekannten Verfahren, beziehungsweise mildert diese deutlich ab, indem der naßchemische Arbeitsablauf bis zur ersten Metallisierung -falls erforderlich auch der gesamte oben genannte naßchemische Arbeitsablauf inklusive der ersten Metallisierung -vermieden wird. Dies wird erfindungsgemäß dadurch erreicht, daß die Metallisierung der genannten Materialien durch Zersetzung metallorganischer Verbindungen in einem Plasma vorgenommen wird. Hierbei hängt die Schichtdicke von der Behandlungsdauer ab. In der Praxis werden porenfreie Schichten ab einer Schichtdicke von ca. 3μm erzielt, so daß man vorzugsweise auf Schichtdicken zwischen 1 bis 5μ verstärken wird.

Im Falle dickerer, nach dem erfindungsgemäßen Verfahren hergestellter, zusammenhängender Metallschichten kann es auch vorteilhaft sein, eine galvanische Metallisierung direkt anzuschließen.

Eine Erzeugung metallischer Strukturen kann hierbei nach einem der bekannten Verfahren (Additiv-, Semiadditiv-, Substraktivtechnik) erfolgen, zum Beispiel, indem die Substratoberfläche während der Metallisierung durch eine Maske abgedeckt wird, so daß lediglich die Stellen freigelassen werden, die die metallischen Strukturen tragen sollen. Andere Ausführungsformen der Strukturierung. zum Beispiel mit Hilfe von Siebdrucklacken, Fotolacken oder Fotoresistfilmen sind in der Technik weit verbreitet und bekannt.

Die Metallisierung nach dem erfindungsgemäßen Verfahren erfolgt durch Zersetzung metallorganischer Verbindungen, vorzugsweise von Elementen der 1. und 8. Nebengruppe in Glimmentladungsplasmen. Es kommen aber auch andere metallorganische Verbindungen von Übergangsmetallen oder Hauptgruppenmetallen, (wie zum Beispiel Zinnverbindungen) zum Einsatz.

Es werden solche metallorganische Verbindungen verwendet, die unzersetzt-eventuell unter Erwärmung - in die Gasphase überführt werden können, wie zum Beispiel $\pi$-Allyl-$\pi$-Cyclopentadienyl-Palladium, Trimethyl-$\pi$-Cyclopentadientyl-Platin, Dimethyl-Gold-acetylacetonate, Kupfer-hexafluor-acetylacetonat, Rutheniumacetylacetonat, Acetylacetonato-(1,5-cyclooctadien-iridium(1), Cyclopentadienyl-(difluor-tert.-butylphosphin)-kupfer, Molybdänhexacarbonyl und Zinntetraalkyle.

Als besonders vorteilhaft hat sich die Kombination mehrerer Metalle herausgestellt, deren eines eine besonders gute Haftung zum Substrat und das andere zur nachfolgenden Metallschicht besitzt. Im Beispiel ist eine Anwendung beschrieben.

Die Metallisierung erfolgt in normalen Plasmareaktoren, die hauptsächlich als Rohr- oder Tunnelreaktoen oder als Parallelplattenreaktoren und Reaktoren für Coronaentladungen bekannt sind. Für die Herstellung metallischer Filme und Strukturen kann das Plasma sowohl mit Gleichstrom als auch mit Wechselstrom oder Hochfrequenz (inklusive Mikrowellen), im allgemeinen im kHz- oder MHz-Bereich erzeugt werden. Der Druck in der Plasmakammer beträgt 0,1 - 2,0 Pa.

Die für die Metallisierung nach erfindungsgemäßen Verfahren benutzten metallorganischen Verbindungen werden dem Plasmareaktor gasförmig zugeführt, vorzugsweise durch Sublimation oder Verdampfung. Sie können für sich allein benutzt werden, im allgemeinen verdünnt man sie aber mit Trägergasen, um gleichmäßige porenfreie Schichten zu erhalten. Als Trägergase eignen sich inerte Gase, wie Argon und Helium oder reduzierende Gase wie Wasserstoff; auch Gemische können eingesetzt werden. Die Einspeisung der Organo-Metallverbindungen erfolgt nach Einstellung des Vakuums außerhalb der Glimmentladungszone in den Strom des Trägergases, so daß im eigentlichen Reaktionsbereich eine gleichmäßige Gasmischung vorliegt. Der Vorratsbehälter für die Metallverbindung wird zweckmäßigerweise mit einer Vorrichtung zum Heizen versehen, um schwerer sublimierbare Metallverbindungen in ausreichender Menge in den Gastrom zu führen.

Eine besondere Ausführungsform des erfindungsgemäßen Verfahrens besteht darin. daß vor dem Metallisierungsprozeß in der Plasmaentladung ein Plasma-Ätzprozeß vorgenommen wird, um die Substratoberfläche zu reinigen und für die Aufnahme der Metallschicht empfänglich zu machen. Die Ausführungsform des Reaktors und der Verfahrensbedingungen unterscheiden sich im Prinzip nicht von dem Plasma-Metallisierungsprozeß. Selbstverständlich werden jedoch beim Plasma-Ätzprozeß keine metallorganischen Verbindungen verwendet. Vorzugsweise werden dem inerten Trägergas reaktive Gase, wie zum Beispiel Sauerstoff oder Tetrafluormethan zugesetzt.

Die Leistungsdichten betragen für die Vorbehandlung 0,1 - 1 Watt / cm$^2$, für die Abscheidung der dünnen Filme liegen die Leistungsdichten zwischen 0.01 - 1 Watt / cm$^2$. Die Elektrode ist entweder geerdet oder befindet sich auf einem negativen Feld bias von einigen 100 Volt je nach eingespeister Leistung.

Die Temperatur der Substrat-Elektrode kann variiert werden, vorzugsweise zwischen 20 und 250° C, limitiert durch die Temperaturbeständigkeit des Kunststoffes.

Die Substrate werden mit einer Maske aus Aluminium versehen, so daß die Bereiche auf dem Plättchen frei bleiben, die die Leiterbahnstrukturen tragen sollen. Die Polyimidsubstrate werden im Reinigungsbeziehungsweise Ätzplasma vorbehandelt und anschließend mittels Plasma -CVB mit einem Metallfilm beschichtet. Die metallisierten Flächen werden zunächst im reduktiven Kupfer-oder Nickelbad und dann im elektrolytischen Bad auf ca. 20$\mu$m verstärkt. Nach einer Temperung von mindestens einer Stunde bei 100° C wird mit Hilfe des Schältestes für Folienmaterial oder Polyimidplatten eine Haftung von 1 bis 1,5 Newton / mm bestimmt. Beim Schältest findet, wie REM-Aufnahmen zeigen, ein Materialbruch statt.

Folgende Beispiele dienen zur Erläuterung der Erfindung:

BEISPIEL 1

ABSCHEIDUNG VON PALLADIUM AUF POLYIMID

| Reaktortyp: | Parallelplattenreaktor, HF-Substratelektrode |
|---|---|
| Frequenz: | 13,56 MHz |
| Substrat: | Polyimidselektrolux auf Glas |
| Temperatur: | 298 K |

a) Vorbehandlung:

| Sputtergas: | Argon |
|---|---|
| Druck : | 16 Pascal |
| Flow: | 100 sccm |
| Self-bias: | 450 Volt |
| Leistungsdichte: | 0.4 Watt/cm$^2$ |
| Behandlungsdauer: | 2 Minuten |

b) Bekeimung

| Metallorganische Verbindung : | $\pi$-Allyl-$\pi$-cyclopentadienylpalladium |
|---|---|
| Temperatur der Vorlage: | 323 K |
| Trägergas: | Argon Flow : 100 sccm |
| Druck: | 16 Pascal |
| Leistungsdichte: | 0.08 Watt / cm$^2$ |
| Self-bias : | 180 Volt |
| Dauer: | 10 Minuten |

c) Nachbehandlung

Tempern der Proben nach der naßchemischen Verkupferung von 1 Stunde bei 373 K.

BEISPIEL 2

ABSCHEIDUNG VON GOLD AUF POLYIMID

| Reaktortyp: | Parallelplattenreaktor, Substratelektrode geerdet |
|---|---|
| Frequenz: | 13,56 MHz |
| Substrat: | Polyimidfoliecaptun HS 200 Temperatur:523 K |

| A. Vorbehandlung | |
|---|---|
| Ätzgas: | O$_2$ / Argon (1:1) |
| Druck | 26 Pascal |
| Flow: | je 50 sccm Argon und Sauerstoff |
| Leistungsdichte: | 0,5 cm$^2$ |
| Dauer: | 5 Minuten |

| B. Metallisierung | |
|---|---|
| Metallorganische Verbindung : | Dimethyl-Gold-acetylacetonat |
| Temperatur der Vorlage: | 313 K |
| Trägergas: | Argon |
| Flow: | 100 sccm |
| Druck: | 26 Pascal |
| Leistungsdichte | 0.6 Watt /cm$^2$ |
| Dauer: | 5 Minuten |

BEISPIEL 3

ABSCHEIDUNG VON MOLYBDÄN AUF POLYIMID

| Reaktortyp: | Parallelplattenreaktor mit geerdeter Substratelektrode |
|---|---|
| Frequenz: | 13,56 MHz |
| Substrat: | Polyimidplatten |
| Temperatur: | 448 K |

| A. Vorbehandlung | |
|---|---|
| Sputtergas: | Argon |
| Flow: | 7.5 sccm |
| Druck | 20 Paskal |
| Leistungsdichte: | 0.6 Watt / cm$^2$ |
| Dauer: | 10 Minuten |

| B. Abscheidung des Molybdänfilms | |
|---|---|
| Metallorganische Verbindung : | Molybdän-hexacarbonyl |
| Temperatur der Vorlage: | 293 K |
| Trägergas: | Argon / H$_2$ (2:1) |
| Flow: | 7.5 sccm |
| Druck: | 20 Paskal |
| Leistungsdichte : | 0.6 Watt /cm$^2$ |
| Dauer: | 60 Minuten |

BEISPIEL 4

Abscheidung von Palladium - Platin auf Polyimid

| Reaktortyp: | Parallelplattenreaktor , HF - Substratelektrode |
|---|---|
| Frequenz: | 13,56 MHz |
| Substrat: | Polyimidplatten |
| Temperatur: | 293 K |

| A. Vorbehandlung | |
|---|---|
| Ätzgas: | O$_2$ / Argon |
| Flow: | 35 sccm O$_2$ , 35 sccm Argon |
| Druck: | 10 Paskal |
| Leistungsdichte: | 0.4 Watt / cm$^2$ |
| Dauer: | 10 Minuten |

| B. Metallisierung | |
|---|---|
| Metallorganiche Verbindungen: | $\pi$-cyclopentadienyl-trimethylplatin $\pi$-allyl-$\pi$-cyclopentadienylpalladium |
| Trägergas: | Argon |
| Flow: | 100 sccm |
| Druck: | 16 Paskal |
| Temperatur der Vorlage: | 313 K |
| Leistungsdichte: | 0.4 cm$^2$ |
| self-filed | 400 Volt |
| Dauer: | je 5 Minuten |

**Ansprüche**

1. Verfahren zur Herstellung metallischer Strukturen auf Nichtleitern durch Zersetzung metallorganischer Verbindungen in einer Glimmentladung unter Bildung eines metallischen Films, dadurch gekennzeichnet, daß als Nichtleiter Polyimid verwendet wird.

2. Verfahren nach Anspruch 1, dadurch gekennzeichnet, daß die Oberfläche der Nichtleiter vor dem Metallisierungsprozess einem Ätz- und Reinigungsprozess in einer Glimmentladung unterworfen wird.

3. Verfahren nach Anspruch 1, dadurch gekennzeichnet, daß der in der Glimmentladung bei der Metallisierung erhaltene Film in einem Bad zur chemisch reduktiven Metallabscheidung, vorzugsweise einem chemisch reduktiven Kupferbad oder einem chemisch reduktiven Nickelbad, verstärkt wird.

4. Verfahren nach Anspruch 1, dadurch gekennzeichnet, daß die Strukturen durch Auflegen von Masken oder durch Auftragen von Siebdrucklacken oder Fotolacken vorgegeben werden.

5. Verfahren nach Anspruch 1, dadurch gekennzeichnet, daß die Strukturen nach der Metallisierung mit Hilfe von Fotoresist, Fotolacken oder Siebdrucklacken erzeugt werden.

6. Verfahren nach Anspruch 1, dadurch gekennzeichnet, daß zur Abscheidung des metallischen Films organische Kupferverbindungen verwendet werden.

7. Verfahren nach Anspruch 1, dadurch gekennzeichnet, daß zur Abscheidung des metallischen Films organische Palladiumverbindungen verwendet werden.

8. Verfahren nach Anspruch 1, dadurch gekennzeichnet, daß zur Abscheidung des metallischen Films organische Platinverbindungen verwendet werden.

9. Verfahren nach Anspruch 1, dadurch gekennzeichnet, daß zur Abscheidung des metallischen Films organische Goldverbindungen verwendet werden.

10. Verfahren nach Anspruch 1, dadurch gekennzeichnet, daß zur Abscheidung des metallischen Films Gemische organischer Metallverbindungen, vorzugsweise Palladium-und Platinverbindungen verwendet werden.

11. Verfahren nach Anspruch 1, dadurch gekennzeichnet, daß zur Abscheidung des metallischen Films organische Nickelverbindungen verwendet werden.

12. Verfahren nach Anspruch 1, dadurch gekennzeichnet, daß zur Abscheidung des metallischen Films organische Kobaltverbindungen verwendet werden.

13. Verfahren nach Anspruch 1, dadurch gekennzeichnet, daß zur Abscheidung des metallischen Films organische Rutheniumverbindungen verwendet werden.

14. Verfahren nach Anspruch 1, dadurch gekennzeichnet, daß zur Abscheidung des metallischen Films organische Zinnverbindungen verwendet werden.

15. Verfahren nach Anspruch 1, dadurch gekennzeichnet, daß zur Abscheidung des metallischen Films organische Molybdänverbindungen verwendet werden.

16. Verfahren nach Anspruch 1, dadurch gekennzeichnet, daß zur Abscheidung des metallischen Films organische Rhodiumverbindungen verwendet werden.

17. Verfahren nach Anspruch 1, dadurch gekennzeichnet, daß zur Abscheidung des metallischen Films organische Iridiumverbindungen verwendet werden.

18. Verfahren nach Anspruch 1, dadurch gekennzeichnet, daß zur Abscheidung des metallischen Films organische Qsmiumverbindungen verwendet werden.

19. Verfahren nach Anspruch 1, dadurch gekennzeichnet, daß ein mit Füllstoffen zweckmäßigerweise $Al_2O_3$ oder $SiO_2$. angereichertes Polyimid verwendet wird.

| | Europäisches Patentamt | EUROPÄISCHER RECHERCHENBERICHT | Nummer der Anmeldung |
|---|---|---|---|
| | | | EP 88 12 0848 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 195 223 (SCHERING) <br> * Ansprüche * <br> --- | 1,3-7, 14 | C 23 C 16/18 <br> C 23 C 16/56 <br> H 05 K 3/00 |
| A | EP-A-0 027 625 (RUHRCHEMIE) <br> * Zusammenfassung * <br> --- | 11,12, 15 | |
| A | US-A-4 250 210 (CROSBY et al.) <br> * Zusammenfassung * <br> --- | 13 | |
| A | US-A-3 594 216 (CHARLES et al.) <br> * Anspruch 3 * <br> --- | 8 | |
| A | CHEMICAL ABSTRACTS, Band 102, Nr. 18, May 1985, Seite 246, Zusammenfassung Nr. 153242e, Columbus, Ohio, US; J.T. HARDING et al.: "Platinum group coatings for refractory metals", & GOV. REP. ANNOUNCE. INDEX (U.S.) 1984, 84(23), 104 <br> --- | 17 | |
| A | RESEARCH DISCLOSURE, Nr. 272, Dezember 1986, pages 729-730, New York, US; "Gas phase, laser induced deposition of gold onto polymide" <br> --- | 9 | RECHERCHIERTE SACHGEBIETE (Int. Cl.4) <br><br> C 23 C |
| A | DE-A-3 222 491 (FUJI ELECTRIC CO.) <br> * Zusammenfassung * <br> ----- | 2 | |

Der vorliegende Recherchenbericht wurde für alle Patentansprüche erstellt

| Recherchenort | Abschlußdatum der Recherche | Prüfer |
|---|---|---|
| DEN HAAG | 02-06-1989 | PATTERSON A.M. |